# EUROPEAN PATENT APPLICATION

(11) **EP 4 770 415 A2**
(43) Date of publication of application: **01.07.2026**
(21) Application number: 25227600.1
(22) Date of filing: 30.12.2025
(51) Int. Cl.: H10W 74/10

(54) **ELEMENT PACKAGE, PACKAGING SUBSTRATE COMPRISING THE SAME AND MANUFACTURE METHOD FOR THE SAME**

(30) Priority: 31.12.2024 US 202463740328 P
(71) Applicant: Absolics Inc., Covington, GA 30014 (US)
(72) Inventor: KIM, Younggeun, Covington, Georgia, 30014 (US); KIM, Hyejin, Covington, Georgia, 30014 (US)
(74) Representative: BCKIP Part mbB

(57) **Abstract**

A device package according to the present disclosure comprises at least one device and an encapsulation layer surrounding the device. The encapsulation layer comprises a first encapsulation layer surrounding an upper surface of the device and a second encapsulation layer disposed below the first encapsulation layer. The device package further comprises an adhesive layer disposed between the first encapsulation layer and the second encapsulation layer.

In this case, a device package having excellent reliability and long-term durability may be provided, and formation of electrical connection may be facilitated when the device package is mounted in a packaging substrate.

## Description

This application claims the priority benefit of U.S. Provisional Patent Application No. 63/740,328, filed on December 31, 2024.

### TECHNICAL FIELD

The present disclosure relates to a device package, a packaging substrate comprising the same, and a method of manufacturing the same.

### BACKGROUND ART

In manufacturing electronic components, implementing circuits on a semiconductor wafer is referred to as a front-end process (FE: Front-End), and assembling the wafer into a state usable in an actual product is referred to as a back-end process (BE: Back-End), and the back-end process includes a packaging process.

Recently, four core technologies of the semiconductor industry that have enabled rapid development of electronic products include semiconductor technology, semiconductor packaging technology, manufacturing process technology, and software technology. Semiconductor technology has been developed in various forms, such as sub-micron or nano-scale line widths, tens of millions or more cells, high-speed operation, and large amounts of heat dissipation; however, technology for perfectly packaging the same has not been sufficiently supported. Accordingly, electrical performance of a semiconductor may be determined by packaging technology and electrical connections associated therewith rather than by performance of the semiconductor technology itself.

As the electronic industry develops, electronic products are also required to have high density, multifunctionality, and miniaturization. Embedded device substrates and packages embed passive devices or active devices inside a package substrate. Such a method may shorten circuit lengths and improve electrical characteristics, and may also increase reliability of the package substrate and reduce manufacturing costs.

### SUMMARY

A device package according to one embodiment of the present specification comprises at least one device and an encapsulation layer surrounding the device.

The encapsulation layer comprises a first encapsulation layer surrounding an upper surface of the device and a second encapsulation layer disposed below the first encapsulation layer.

The device package further comprises an adhesive layer disposed between the first encapsulation layer and the second encapsulation layer.

At least a portion of the adhesive layer may be disposed in contact with a lower surface of the first encapsulation layer.

A ratio of an area of the adhesive layer to an area of a lower surface of the device package may be 15% or more.

The adhesive layer may comprise any one selected from the group consisting of a silicone-based adhesive, an epoxy-based adhesive, an acrylic-based adhesive, and combinations thereof.

The device package may comprise a first point located on a lower surface of the device and a second point located on a lower surface of the second encapsulation layer.

A minimum value of a distance between the first point and the second point may be 5 µm to 100 µm.

A thickness of the second encapsulation layer disposed under the device may be 5 µm to 100 µm.

A packaging substrate according to another embodiment of the present specification comprises a core layer and a cavity portion which is a space formed by recessing a portion of an upper surface of the core layer.

The packaging substrate comprises the device package disposed in the cavity portion.

A method of manufacturing a device package according to still another embodiment of the present specification comprises a preliminary device package preparing step of preparing a preliminary device package comprising at least one device and a first encapsulation layer surrounding an upper surface of the device, an adhesive layer forming step of forming an adhesive layer disposed on a lower surface of the preliminary device package, and a second encapsulation layer forming step of forming a second encapsulation layer disposed below the lower surface of the preliminary device package on which the adhesive layer is formed to manufacture the device package.

The adhesive layer forming step may comprise an adhesive layer disposing process of disposing an adhesive layer on the lower surface of the preliminary device package and a plasma processing process of plasma-treating a lower surface of the preliminary device package on which the adhesive layer is disposed.

In the adhesive layer forming step, at least a portion of the adhesive layer may be formed to be in contact with a lower surface of the device.

In the adhesive layer forming step, the adhesive layer may be formed such that a ratio of an area of the adhesive layer to an area of the lower surface of the preliminary device package is 15% or more.

The adhesive layer may comprise any one selected from the group consisting of a silicone-based adhesive, an epoxy-based adhesive, an acrylic-based adhesive, and combinations thereof.

### BRIEF DESCRIPTION OF THE DRAWINGS

FIG. 1 is a cross-sectional view illustrating a device package according to one embodiment of the present disclosure.
FIG. 2 is a cross-sectional view illustrating a packaging substrate according to another embodiment of the present disclosure.

### DETAILED DESCRIPTION

Hereinafter, embodiments will be described in detail with reference to the accompanying drawings so that a person having ordinary skill in the art to which the present disclosure pertains may easily carry out the present disclosure. However, the present invention may be embodied in various different forms and is not limited to the embodiments described herein. Throughout the specification, the same reference numerals are assigned to similar parts.

Throughout the present specification, the term "combinations thereof" included in a Markush-type expression means one or more mixtures or combinations selected from a group consisting of the components recited in the Markush-type expression, and means including one or more selected from the group consisting of the components.

Throughout the present specification, terms such as "first," "second," or "A," "B" are used to distinguish the same terms from each other. In addition, unless the context clearly indicates otherwise, singular expressions include plural expressions.

In the present specification, the term "-based" refers to a compound comprising "-" itself or a derivative thereof.

In the present specification, the meaning that B is disposed on A means that B is disposed directly in contact with A, or that B is disposed on A with another layer interposed therebetween, and is not construed as being limited to B being disposed in contact with a surface of A.

In the present specification, the meaning that B is connected to A means that A and B are directly connected, or that A and B are connected through another component therebetween, and unless otherwise specified, is not construed as being limited to A and B being directly connected.

In the present specification, unless otherwise specified, singular expressions are construed to include singular or plural meanings as interpreted in context.

In the present specification, shapes, relative sizes, angles, and the like of respective components shown in the drawings are illustrative and may be exaggerated for purposes of description, and scope of the present invention are not construed as being limited to the drawings.

In the present specification, the meaning that A and B are adjacent to each other means that A and B are disposed in contact with each other, or that A and B are disposed close to each other without being in contact with each other. Unless otherwise specified, the expression that A and B are adjacent to each other is not construed as being limited to A and B being disposed in contact with each other.

In the present specification, unless otherwise specified, physical property values of respective components in the packaging substrate are construed as values measured at room temperature. Room temperature is 20°C to 25°C.

In a case of a device package mounted in a packaging substrate, an encapsulation layer may surround a device so as to have a uniform thickness on upper and lower surfaces of the device. Through this, it may be easy to form a wiring layer in a vertical direction in the encapsulation layer surrounding the device.

A device package having the above-described features may be provided by first forming an encapsulation layer surrounding an upper surface side of the device, and then forming an encapsulation layer surrounding a lower surface side of the device. In particularly, in this case, a composition for forming an encapsulation layer injected to a lower side of the device may be cured while being in contact with the encapsulation layer on the upper surface side of the device, which has already been cured. When the device package is manufactured by such a method, sufficient adhesive strength may not be formed between the encapsulation layer formed on the upper surface side of the device and the encapsulation layer formed on the lower surface side of the device. Such a problem may cause a reliability issue of the device package and may cause delamination between encapsulation layers.

Inventors of the present disclosure have experimentally confirmed that, by introducing technical features described below into a device package, it may be possible to provide excellent electrical reliability and long-term durability, and to facilitate formation of an electrical connection when mounted in a packaging substrate, thereby completing the present disclosure.

Hereinafter, embodiments will be described in detail.

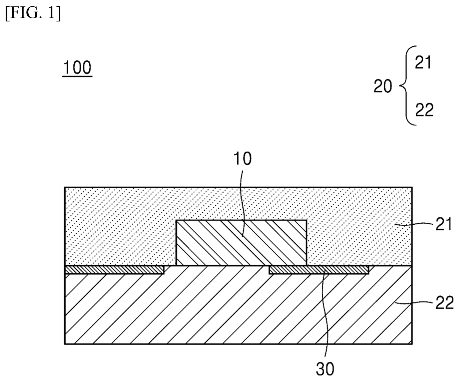

FIG. 1 is a cross-sectional view illustrating a device package according to one embodiment of the present disclosure. Hereinafter, the present disclosure will be described with reference to FIG. 1.

### Device Package

A device package (100) according to one embodiment of the present disclosure comprises at least one device (10) and an encapsulation layer (20) surrounding the device (10). The encapsulation layer (20) comprises a first encapsulation layer (21) surrounding an upper surface of the device (10) and a second encapsulation layer (22) disposed below the first encapsulation layer (21). The device package (100) further comprises an adhesive layer (30) disposed between the first encapsulation layer (21) and the second encapsulation layer (22).

The device (10) may include not only semiconductor devices such as a CPU, a GPU, and a memory chip, but also a capacitor device, a transistor device, an impedance device, and other modules. That is, any semiconductor device mounted in a semiconductor apparatus may be applied as the device (10) without limitation.

The device package (100) may comprise one device (10), or may comprise two or more devices (10). When the device package (100) comprises two or more devices (10), the respective devices (10) may be disposed spaced apart from each other, or may be disposed in contact with each other.

The encapsulation layer (20) may support and protect the device (10) and electrical connections included in the device package (100), and may impart insulating properties to a target region in the device package (100).

The encapsulation layer (20) may comprise a material capable of appropriately fixing the device (10) and preventing electrical short circuits.

The encapsulation layer (20) may comprise an epoxy-based resin. The epoxy-based resin may be any one selected from the group consisting of a bisphenol A-type epoxy-based resin, a brominated bisphenol A-type epoxy-based resin, a bisphenol F-type epoxy-based resin, a biphenyl-type epoxy-based resin, a novolac-type epoxy-based resin, an alicyclic epoxy-based resin, a naphthalene-type epoxy-based resin, a silicone epoxy-based copolymer resin, and combinations thereof.

The encapsulation layer (20) may further comprise other additive in addition to the resin described above. The additive may be applied without limitation as long as it is commonly used in the molding compound field. By way of example, a curing agent, a curing catalyst, a coupling agent, a defoaming agent, a flame retardant, a surfactant, and an inorganic filler may be applied as the additives.

The encapsulation layer (20) may comprise the first encapsulation layer (21) surrounding an upper surface of the device (10) and the second encapsulation layer (22) disposed below the first encapsulation layer (21).

The first encapsulation layer (21) may surround the upper surface of the device (10) while being in contact with the upper surface of the device (10). Another component may be disposed between the first encapsulation layer (21) and the upper surface of the device (10). The first encapsulation layer (21) may surround at least part of a side surface of the device (10). The first encapsulation layer (21) may surround the side surface of the device (10) while being in contact with the side surface of the device (10). Another component may be disposed between the first encapsulation layer (21) and the side surface of the device (10). The first encapsulation layer (21) may surround a lower surface of the device (10). The first encapsulation layer (21) may surround the lower surface of the device (10) while being in contact with the lower surface of the device (10). Another component may be disposed between the first encapsulation layer (21) and the lower surface of the device (10).

The second encapsulation layer (22) is disposed below the first encapsulation layer (21). The second encapsulation layer (22) may surround the lower surface of the device (10) while being in contact with the lower surface of the device (10). Another component may be disposed between the second encapsulation layer (22) and the lower surface of the device (10). The second encapsulation layer (22) may surround at least part of the side surface of the device (10). The second encapsulation layer (22) may surround the side surface of the device (10) while being in contact with the side surface of the device (10). Another component may be disposed between the second encapsulation layer (22) and the side surface of the device (10).

The first encapsulation layer (21) and the second encapsulation layer (22) may be disposed in contact with each other in some regions within the device package (100). In this case, an interface between the first encapsulation layer (21) and the second encapsulation layer (22) may not be observed.

The first encapsulation layer (21) and the second encapsulation layer (22) may comprise the same composition, or may comprise different compositions.

The device package (100) may control a thickness of the encapsulation layer (20) surrounding the device (10) within a range preset in the present disclosure. In this case, while the device (10) is stably protected, it may be easy to form wiring of an electrically conductive layer for embedding on upper and/or lower sides of the device (10) in the device package (100).

The device package (100) may comprise a first point located on a lower surface of the device (10) and a second point located on a lower surface of the second encapsulation layer (22). A minimum value of a distance between the first point and the second point may be 5 µm to 100 µm. The minimum value may be 10 µm or more. The minimum value may be 15 µm or more. The minimum value may be 90 µm or less. The minimum value may be 80 µm or less. The minimum value may be 70 µm or less.

The device package (100) may comprise a third point located on an upper surface of the device (10) and a fourth point located on an upper surface of the first encapsulation layer (21). A minimum value of a distance between the third point and the fourth point may be 5 µm to 100 µm. The minimum value may be 10 µm or more. The minimum value may be 15 µm or more. The minimum value may be 90 µm or less. The minimum value may be 80 µm or less. The minimum value may be 70 µm or less.

In this case, it may be possible to help accurately and densely form fine patterns on upper and/or lower sides of the device (10) in the device package (100).

The device package (100) may further comprise an adhesive layer (30) disposed between the first encapsulation layer (21) and the second encapsulation layer (22). The adhesive layer (30) may have excellent adhesive properties with respect to the first encapsulation layer (21) and the second encapsulation layer (22). The adhesive layer (30) may allow the first encapsulation layer (21) and the second encapsulation layer (22) to be stably bonded to each other, thereby improving durability of the device package (100) and stably maintaining electrical connections in the device package (100).

The adhesive layer (30) may be disposed below the first encapsulation layer (21). At least a portion of the adhesive layer (30) may be disposed in contact with a lower surface of the first encapsulation layer (21). At least a portion of the adhesive layer (30) may be disposed below the device (10). At least a portion of the adhesive layer (30) may be disposed in contact with a lower surface of the device (10). At least a portion of the adhesive layer (30) may be disposed on the second encapsulation layer (22). At least a portion of the adhesive layer (30) may be disposed in contact with an upper surface of the second encapsulation layer (22). When the adhesive layer (30) is disposed as described above, it may be possible to effectively suppress occurrence of cracks and delamination of the encapsulation layer (20) in the device package (100).

A ratio of an area of the adhesive layer (30) to an area of a lower surface of the device package (100) may be 15% or more. The ratio may be 20% or more. The ratio may be 25% or more. The ratio may be 30% or more. The ratio may be 35% or more. The ratio may be 40% or more. The ratio may be 45% or more. The ratio may be 50% or more. The ratio may be 80% or less. The ratio may be 70% or less.

A ratio of an area of the adhesive layer (30) to an area of an upper surface of the device package (100) may be 15% or more. The ratio may be 20% or more. The ratio may be 25% or more. The ratio may be 30% or more. The ratio may be 35% or more. The ratio may be 40% or more. The ratio may be 45% or more. The ratio may be 50% or more. The ratio may be 80% or less. The ratio may be 70% or less.

In this case, the adhesive layer (30) may provide sufficient bonding force between the first encapsulation layer (21) and the second encapsulation layer (22), and convenience of a process of forming the adhesive layer (30) may be improved.

The adhesive layer (30) may comprise any one selected from the group consisting of a silicone-based adhesive, an epoxy-based adhesive, an acrylic-based adhesive, and combinations thereof. Such adhesives may provide further improved adhesive force through plasma treatment described below, and may stably suppress degradation and deterioration of the adhesive layer (30) caused by the plasma treatment.

Silicone-based adhesives, epoxy-based adhesives, and acrylic-based adhesives may be applied without limitation as long as they are commonly used in the adhesive field.

### Packaging Substrate

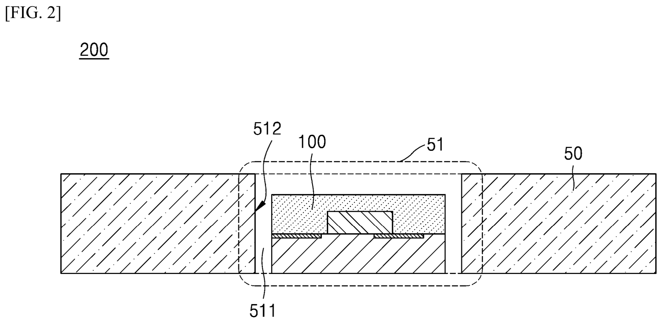

FIG. 2 is a cross-sectional view illustrating a packaging substrate according to another embodiment of the present disclosure. Hereinafter, the present disclosure will be described with reference to FIG. 2.

The description given above with reference to FIG. 1 is equally applicable to the device package (100). Hereinafter, differences will be mainly described.

A packaging substrate (200) according to another embodiment of the present disclosure comprises a core layer (50) and a cavity portion (51), which is a space formed by recessing an upper surface side of the core layer (50). The packaging substrate (200) comprises the device package (100) disposed in the cavity portion (51).

The core layer (50) may function as a support layer in the packaging substrate (200). The core layer (50) may be applied without limitation as long as it may be used as a support layer in the packaging substrate (200) field. By way of example, the core layer (50) may be a glass substrate, a ceramic substrate, or an organic substrate.

In particular, the core layer (50) may be a glass substrate. When a glass substrate is applied as the core layer (50), it may be advantageous for implementing fine patterns and may stably suppress occurrence of parasitic devices.

By way of example, the glass substrate may include alkali borosilicate plate glass, alkali-free borosilicate plate glass, and alkali-free alkali-earth borosilicate plate glass, and any plate glass applicable as an electronic component may be applied. As the glass substrate, a glass substrate for an electronic device may be applied, and by way of example, those manufactured by Schott, AGC, Corning, and the like may be applied, but the present disclosure is not limited thereto.

The core layer (50) may comprise a through via penetrating the core layer (50) in a thickness direction thereof.

The through via may comprise an internal space and an inner via surface surrounding the internal space. The internal space refers to an empty space, and the inner via surface refers to a surface of the core layer (50) formed on an inner side of the through via.

The through via may have a diameter that varies in the thickness direction of the core layer (50). The through via may have a substantially uniform diameter in the thickness direction of the core layer (50).

A surface of the core layer (50) may comprise an upper surface and a side surface connected to the upper surface and formed in the thickness direction of the core layer (50). The surface of the core layer (50) may comprise a lower surface facing the upper surface.

That the side surface is formed in the thickness direction of the core layer (50) is construed to include not only that the side surface forms a right angle with the upper surface of the core layer (50), but also that at least a portion of the side surface forms an angle other than 90 degrees (an inclined angle) with the upper surface.

The side surface may be a planar surface or a curved surface.

A thickness of the core layer (50) may be 100 µm or more. The thickness may be 200 µm or more. The thickness may be 300 µm or more. The thickness may be 3000 µm or less. The thickness may be 2000 µm or less. The thickness may be 1000 µm or less. In this case, the core layer (50) may have mechanical properties suitable for application to the packaging substrate (200).

The cavity portion (51) may be formed by recessing an upper surface side of the core layer (50). The cavity portion (51) may be formed by recessing a portion of the upper surface side of the core layer (50) in the thickness direction of the core layer (50). The cavity portion (51) may be formed to penetrate the core layer (50) in the thickness direction thereof.

The cavity portion (51) may comprise a device package mounting space (511) and a cavity inner surface (512) surrounding the device package mounting space (511). The cavity portion (51) may comprise a cavity opening (not shown) disposed on the upper surface side of the core layer (50), a cavity inner surface (512) connected to the cavity opening and extending in the thickness direction of the core layer (50), and an internal space surrounded by the cavity inner surface (512).

The cavity opening may be disposed in contact with the upper surface of the core layer (50). The cavity opening may constitute an inner edge of the upper surface of the core layer (50).

That the cavity inner surface (512) is formed to extend in the thickness direction of the core layer (50) is construed to include not only that the cavity inner surface (512) forms a right angle with the upper surface of the core layer (50), but also that at least a portion of the cavity inner surface (512) forms an angle other than 90 degrees (an inclined angle) with the upper surface.

The cavity inner surface (512) may be a planar surface or a curved surface.

The device package mounting space (511) is a space in which the device package (100) is mounted. The device package mounting space (511) may be an internal space formed by recessing an upper surface side of the core layer (50).

As the device package (100), the device package (100) described above may be applied. Descriptions of the device package (100) are omitted as being redundant.

After disposing the device package (100) in the cavity portion, a remaining device package mounting space (511) in the cavity portion may be filled with an encapsulation layer. The encapsulation layer may be applied without limitation as long as it is commonly used in the packaging substrate field.

A redistribution layer may be formed on and/or under the core layer. The redistribution layer may comprise an electrically conductive layer which is a conductive layer transmitting electrical signals, and an insulating layer surrounding at least a portion of the electrically conductive layer.

The redistribution layer may be applied without limitation as long as it is commonly used in the packaging substrate field.

### Method of Manufacturing Device Package

A method of manufacturing a device package according to another embodiment of the present disclosure comprises a preliminary device package preparing step of preparing a preliminary device package comprising at least one device and a first encapsulation layer surrounding an upper surface of the device, an adhesive layer forming step of forming an adhesive layer disposed on a lower surface of the preliminary device package, and a second encapsulation layer forming step of forming a second encapsulation layer disposed below the lower surface of the preliminary device package on which the adhesive layer is formed to manufacture the device package.

### Preliminary Device Package Preparing Step

In the preliminary device package preparing step, a preliminary device package comprising at least one device and a first encapsulation layer surrounding an upper surface of the device may be prepared. As the device and the first encapsulation layer, the device and the first encapsulation layer described above may be applied. Descriptions of the device and the first encapsulation layer are omitted as being redundant.

A lower surface of the device may be exposed toward a lower surface side of the preliminary device package. The lower surface of the device may be surrounded by the first encapsulation layer.

In the preliminary device package preparing step, a preliminary device package in which the device is already surrounded by the first encapsulation layer may be introduced, or a preliminary device package may be prepared by forming the first encapsulation layer so as to surround the upper surface of the device.

The first encapsulation layer may be formed from a composition for forming a first encapsulation layer. Specifically, the device may be disposed in an internal space formed in a mold. When two or more devices are provided, the respective devices may be disposed in the mold according to a predesigned spacing. The mold may be applied without limitation as long as it may be commonly used in the device packaging field.

Thereafter, the composition for forming the first encapsulation layer may be injected into the internal space of the mold to fill portions other than portions occupied by the device in the internal space of the mold with the composition for forming the first encapsulation layer. The composition for forming the first encapsulation layer may be cured to form the first encapsulation layer.

The composition for forming the first encapsulation layer may comprise an epoxy-based resin and a curing agent. The epoxy-based resin may comprise two or more epoxy groups. The epoxy-based resin may be any one selected from the group consisting of a bisphenol A-type epoxy-based resin, a brominated bisphenol A-type epoxy-based resin, a bisphenol F-type epoxy-based resin, a biphenyl-type epoxy-based resin, a novolac-type epoxy-based resin, an alicyclic epoxy-based resin, a naphthalene-type epoxy-based resin, a silicone epoxy-based copolymer resin, and combinations thereof.

A weight-average molecular weight of the epoxy-based resin may be 1,000 g/mol or less. The weight-average molecular weight may be 800 g/mol or less. The weight-average molecular weight may be 600 g/mol or less. The weight-average molecular weight may be 100 g/mol or more.

A curing agent according to the present disclosure is not limited as long as it may function as a curing agent of the epoxy-based resin. By way of example, the curing agent may include an acid anhydride-based curing agent, an aromatic amine, a phenol resin, and an imidazole-based compound.

The composition for forming the first encapsulation layer may include the curing agent in an amount of 0.3 equivalents or more per 1 equivalent of epoxy groups in the epoxy-based resin. The composition for forming the first encapsulation layer may include the curing agent in an amount of 0.5 equivalents or more per 1 equivalent of epoxy groups in the epoxy-based resin. The composition for forming the first encapsulation layer may include the curing agent in an amount of 0.7 equivalents or more per 1 equivalent of epoxy groups in the epoxy-based resin. The composition for forming the first encapsulation layer may include the curing agent in an amount of 2 equivalents or less per 1 equivalent of epoxy groups in the epoxy-based resin. The composition for forming the first encapsulation layer may include the curing agent in an amount of 1.5 equivalents or less per 1 equivalent of epoxy groups in the epoxy-based resin.

The composition for forming the first encapsulation layer may further comprise a filler. The filler may contribute to the composition for forming the first encapsulation layer having a viscosity within a range preset in the present disclosure, and may help the encapsulation layer have physical properties suitable for a device package.

The filler may comprise inorganic particles. The filler may be inorganic particles. By way of example, the filler may include silica, titania, and alumina.

An average particle diameter of the filler may be 150 nm or less. The average particle diameter may be 120 nm or less. The average particle diameter may be 100 nm or less. The average particle diameter may be 80 nm or less. The average particle diameter may be 10 nm or more. The average particle diameter may be 30 nm or more. In this case, the composition for forming the first encapsulation layer may have viscosity characteristics suitable for filling the internal space in the mold, and may help the first encapsulation layer have desired mechanical properties. In addition, it may be easy to implement an electrically conductive layer having a fine pitch in the first encapsulation layer.

The present disclosure may adjust a filler content in the composition for forming the first encapsulation layer within a range preset in the present disclosure. Through this, the composition for forming the first encapsulation layer may have flow characteristics suitable for smoothly filling the internal space of the mold, and the formed first encapsulation layer may stably protect the device from external impact and thermal shock.

The composition for forming the first encapsulation layer may comprise the filler in an amount of 45 wt% or more. The composition for forming the first encapsulation layer may comprise the filler in an amount of 50 wt% or more. The composition for forming the first encapsulation layer may comprise the filler in an amount of 75 wt% or more. The composition for forming the first encapsulation layer may comprise the filler in an amount of 95 wt% or less. In this case, the composition may have flow characteristics suitable for a molding process. In addition, it may be possible to form an encapsulation layer that stably fixes the device and does not apply excessive stress to the core layer in a high-temperature environment when the device package is mounted on a packaging substrate.

The composition for forming the first encapsulation layer may comprise a solvent. The solvent is not limited as long as it may be commonly applied in the technical field.
By way of example, the solvent may include an aliphatic hydrocarbon solvent, an aromatic hydrocarbon solvent, an ether, and/or an ester.

The composition for forming the first encapsulation layer may further comprise an additive. The additive is not limited as long as it may be commonly applied in the technical field. By way of example, the additive may include a defoaming agent, a coupling agent, a flame retardant, and/or a surfactant.

When injecting the composition for forming the first encapsulation layer into the mold, a temperature of the composition may be 120°C to 250°C. The temperature may be 130°C or more. The temperature may be 200°C or less. The temperature may be 180°C or less. In this case, empty spaces in the mold may be sufficiently filled.

When injecting the composition for forming the first encapsulation layer into the mold, a molding pressure may be 3 MPa or more. The molding pressure may be 4 MPa or more. The molding pressure may be 5 MPa or more. The molding pressure may be 20 MPa or less. Through this, formation of voids in the first encapsulation layer may be stably suppressed.

After completion of injection of the composition for forming the first encapsulation layer into the mold, the composition may be pressurized for a predetermined time. Through this, formation of empty spaces in the first encapsulation layer may be stably suppressed.

After completion of injection of the composition for forming the first encapsulation layer into the mold, a pressurization time may be 30 seconds or more. The pressurization time may be 40 seconds or more. The pressurization time may be 5 minutes or less.

By lowering a temperature of the composition for forming the first encapsulation layer disposed in the internal space of the mold, the composition may be cured to form the first encapsulation layer. A temperature decrease time of the composition for forming the first encapsulation layer may be 50 seconds to 500 seconds.

By forming the first encapsulation layer, a preliminary device package may be prepared.

### Adhesive Layer Forming Step

The adhesive layer forming step of the present disclosure may form an adhesive layer disposed on a lower surface of a preliminary device package.

The adhesive layer forming step may include an adhesive layer disposing process of disposing an adhesive layer on the lower surface of the preliminary device package, and a plasma processing process of plasma-treating the lower surface of the preliminary device package on which the adhesive layer is disposed.

As the adhesive layer applied to the adhesive layer forming step, the adhesive layer described above may be applied. Since the description of the adhesive layer overlaps with the foregoing description, a repeated description thereof will be omitted.

### Adhesive Layer Disposing Process

In the adhesive layer disposing process, the adhesive layer may be disposed on the lower surface of the preliminary device package. The adhesive layer may be disposed below the first encapsulation layer. At least a portion of the adhesive layer may be disposed in contact with a lower surface of the first encapsulation layer. At least a portion of the adhesive layer may be disposed below the device. In the preliminary device package, when at least a portion of a lower surface of the device is exposed to the outside, at least a portion of the adhesive layer may be disposed in contact with the lower surface of the device.

The adhesive layer may be formed such that a ratio of an area of the adhesive layer to an area of the lower surface of the preliminary device package is 15% or more. The ratio may be 20% or more. The ratio may be 25% or more. The ratio may be 30% or more. The ratio may be 35% or more. The ratio may be 40% or more. The ratio may be 45% or more. The ratio may be 50% or more. The ratio may be 80% or less. The ratio may be 70% or less.

In this case, the adhesive layer may contribute to stably fixing and bonding the first encapsulation layer and the second encapsulation layer.

The adhesive layer may comprise any one selected from the group consisting of a silicone-based adhesive, an epoxy-based adhesive, an acrylic-based adhesive, and combinations thereof. Such adhesives may have enhanced adhesive strength according to the plasma processing process, and chemical degradation of the adhesive material due to the plasma processing process may be stably suppressed.

The silicone-based adhesive, the epoxy-based adhesive, and the acrylic-based adhesive may be applied without limitation as long as they are commonly used in the adhesive field.

The adhesive layer may be formed by attaching an adhesive tape to the lower surface of the preliminary device package and then removing a base layer of the adhesive tape.
For example, the adhesive tape may be an adhesive tape manufactured by Tapex Co.

### Plasma Processing Process

In the plasma processing process, a lower surface of the preliminary device package on which the adhesive layer is disposed may be plasma-treated. Through the plasma processing, surface energy of the adhesive layer may be increased, and bonding strength between the adhesive layer and the second encapsulation layer in a second encapsulation layer forming process may be improved. In addition, by also increasing surface energy of a surface of the first encapsulation layer in the lower surface of the preliminary device package, a chemical reaction between a composition for forming the second encapsulation layer and the surface of the first encapsulation layer may be induced, thereby contributing to providing an encapsulation layer with enhanced durability.

In the plasma processing process, any one selected from the group consisting of oxygen gas, argon, nitrogen gas, and combinations thereof may be introduced as an ambient gas.

In the plasma processing process, the ambient gas may be introduced at a flow rate of 3 sccm or more. The ambient gas may be introduced at a flow rate of 5 sccm or more. The ambient gas may be introduced at a flow rate of 30 sccm or less. The ambient gas may be introduced at a flow rate of 20 sccm or less.

In the plasma processing process, plasma power may be 1 W or more. The plasma power may be 3 W or more. The plasma power may be 5 W or more. The plasma power may be 30 W or less. The plasma power may be 25 W or less. The plasma power may be 20 W or less.

The plasma processing process may be performed for 5 seconds or more. The plasma processing process may be performed for 7 seconds or more. The plasma processing process may be performed for 10 seconds or more. The plasma processing process may be performed for 60 seconds or less. The plasma processing process may be performed for 40 seconds or less.

In this case, durability of the encapsulation layer may be effectively enhanced while suppressing excessive damage to surfaces of the adhesive layer and the first encapsulation layer caused by the plasma processing.

### Second Encapsulation Layer Forming Step

In the second encapsulation layer forming step, a second encapsulation layer disposed below a lower surface of the preliminary device package on which the adhesive layer is formed may be formed.

The second encapsulation layer may be formed from a composition for forming the second encapsulation layer. Specifically, the preliminary device package on which the adhesive layer is formed may be disposed in an inner space of a mold. As the mold, the same mold as that applied when forming the first encapsulation layer may be applied.

Thereafter, a composition for forming the second encapsulation layer may be injected into the inner space of the mold so that a remaining portion of the inner space of the mold, excluding a portion occupied by the preliminary device package, is filled with the composition for forming the second encapsulation layer. The composition for forming the second encapsulation layer may be cured to form the second encapsulation layer.

The composition for forming the second encapsulation layer may comprise an epoxy-based resin and a curing agent. As the epoxy-based resin and the curing agent, the epoxy-based resin and the curing agent described above may be applied. Since the description of the epoxy-based resin and the curing agent overlaps with the foregoing description, a repeated description thereof will be omitted.

In the composition for forming the second encapsulation layer, the curing agent may be applied in an amount of 0.3 equivalents or more per 1 equivalent of epoxy groups in the epoxy-based resin. In the composition for forming the second encapsulation layer, the curing agent may be applied in an amount of 0.5 equivalents or more per 1 equivalent of epoxy groups in the epoxy-based resin. In the composition for forming the second encapsulation layer, the curing agent may be applied in an amount of 0.7 equivalents or more per 1 equivalent of epoxy groups in the epoxy-based resin. In the composition for forming the second encapsulation layer, the curing agent may be applied in an amount of 2 equivalents or less per 1 equivalent of epoxy groups in the epoxy-based resin. In the composition for forming the second encapsulation layer, the curing agent may be applied in an amount of 1.5 equivalents or less per 1 equivalent of epoxy groups in the epoxy-based resin.

The composition for forming the second encapsulation layer may further comprise a filler. As the filler, the filler described above may be applied. Since the description of a composition and content of the filler overlaps with the foregoing description, a repeated description thereof will be omitted.

The composition for forming the second encapsulation layer may comprise a solvent. The solvent is not limited as long as it is commonly applicable in the technical field. For example, the solvent may comprise an aliphatic hydrocarbon solvent, an aromatic hydrocarbon solvent, an ether, an ester, or combinations thereof.

The composition for forming the second encapsulation layer may further comprise an additive. The additive is not limited as long as it is commonly applicable in the technical field. For example, the additive may comprise a defoaming agent, a coupling agent, a flame retardant or a surfactant.

When injecting the composition for forming the second encapsulation layer into the mold, a temperature of the composition may be 120°C to 250°C. The temperature may be 130°C or higher. The temperature may be 140°C or higher. The temperature may be 230°C or lower. The temperature may be 200°C or lower.

The composition for forming the second encapsulation layer may be injected into the mold at a pressure of 3 MPa or more. The composition for forming the second encapsulation layer may be injected into the mold at a pressure of 4 MPa or more. The composition for forming the second encapsulation layer may be injected into the mold at a pressure of 5 MPa or more. The composition for forming the second encapsulation layer may be injected into the mold at a pressure of 20 MPa or less.

Through this, formation of voids in the second encapsulation layer may be effectively suppressed.

By lowering a temperature of the composition for forming the second encapsulation layer disposed in the inner space of the mold, the composition may be cured to form the second encapsulation layer. The temperature of the composition for forming the second encapsulation layer may be lowered over 50 seconds to 500 seconds.

By forming the second encapsulation layer, a device package may be provided.

### Electrical Conductive Layer Forming Step

The device package manufacturing method of the present disclosure may further comprise an electrical conductive layer forming step of forming an electrical conductive layer on the first encapsulation layer and/or the second encapsulation layer after the encapsulation layer forming step.

The electrical conductive layer forming step may comprise a through-hole forming process of forming a through hole penetrating the first encapsulation layer and/or the second encapsulation layer in a thickness direction of the device package, and a process of forming an electrical conductive layer in the through hole.

In the through-hole forming process, a resist film may be laminated on a surface of the encapsulation layer on which a hole pattern is to be transferred. After irradiating exposure light in a pattern shape to be transferred onto the resist film and performing development, a patterned resist film may be formed. Using the patterned resist film as an etching mask, the encapsulation layer may be etched, and by removing the patterned resist film, the hole pattern may be transferred to the encapsulation layer.

Lamination, exposure, development, stripping of the resist film, and etching of the encapsulation layer may be applied without limitation as long as they are commonly used in the packaging field.

The electrical conductive layer in the through hole may be formed by a dry method or a wet method.

The dry method is a method in which a seed layer is formed by performing sputtering on a region in which the electrical conductive layer is to be disposed, and the electrical conductive layer is formed by performing plating on the region on which the seed layer is formed. When forming the seed layer, metals such as titanium, chromium, or nickel may be sputtered, and sputtering may be performed by applying copper together with the metals described above. Through sputtering, an anchor effect in which a surface on which the electrical conductive layer is disposed interacts with deposited metal particles may occur, thereby improving adhesion of the electrical conductive layer.

The wet method is a method of forming the seed layer after treating a portion where formation of the electrical conductive layer is required with a primer. The primer may comprise a compound having a functional group such as an amine group. Depending on an intended degree of adhesion, the primer may comprise both a compound having a functional group such as an amine group and a silane coupling agent. When applying the silane coupling agent, a surface to be subjected to primer treatment may be pretreated with the silane coupling agent, and then a compound having an amine group may be applied to the pretreated region to form a primer layer.

After forming the seed layer, metal plating may be performed to form the electrical conductive layer. Copper plating may be applied when forming the electrical conductive layer, but the present disclosure is not limited thereto. Before metal plating, portions in which formation of a conductive layer is not required in the seed layer or the primer layer may be deactivated, or portions in which formation of the conductive layer is required may be activated, and then plating may be performed. As activation or deactivation treatment methods, light irradiation treatment of irradiating light such as a laser of a specific wavelength, chemical treatment, or the like may be applied. However, after performing metal plating without applying activation or deactivation treatment, the electrical conductive layer may be etched and patterned according to a predesigned shape.

Hereinafter, present disclosure will be described in more detail through specific examples. The following examples are merely examples for helping understanding of the present disclosure, and the scope of the present disclosure is not limited thereto.

### Preparation Example: Formation of Device Package

Example 1: After disposing three devices in a mold, a first encapsulation layer surrounding upper surfaces and side surfaces of the devices was formed by injecting CEL-400ZHF, which is an epoxy molding compound composition manufactured by Resonac Corporation, into the mold and curing, thereby preparing a preliminary device package. When injecting the composition for forming the first encapsulation layer, a temperature of the composition was applied as 175 °C, a molding pressure was applied as 7.5 MPa, and a pressurization time was applied as 60 seconds, and the composition was cooled for 180 seconds to be cured. A thickness of the first encapsulation layer formed on the devices was applied as 30 µm.

After removing the preliminary device package from the mold, a silicone-based adhesive tape manufactured by Tapex Co. was attached to a lower surface of the preliminary device package, and then a base layer of the adhesive tape was removed to form an adhesive layer. The adhesive layer was formed such that an area thereof was 50% relative to an entire area of the lower surface of the preliminary device package.

After forming the adhesive layer, the lower surface of the preliminary device package was plasma-treated. During the plasma processing, argon gas was introduced as an ambient gas at a flow rate of 10 sccm, plasma power was applied as 10 W, and the plasma processing was performed for 20 seconds.

After the plasma processing, the preliminary device package was disposed in a mold. The preliminary device package was disposed such that the lower surface faced upward. A composition for forming an encapsulation layer was injected onto the lower surface of the preliminary device package and cured to form a second encapsulation layer, thereby providing a device package. Manufacturing conditions for forming the second encapsulation layer were applied to be the same as those for forming the first encapsulation layer. A thickness of the second encapsulation layer formed below the devices was applied as 30 µm.

Example 2: A device package was provided under the same conditions as in Example 1, except that an epoxy-based adhesive tape manufactured by Tapex Co. was applied as the adhesive layer.

Example 3: A device package was provided under the same conditions as in Example 1, except that an acrylic-based adhesive tape manufactured by Tapex Co. was applied as the adhesive layer.

Comparative Example 1: A device package was provided under the same conditions as in Example 1, except that the adhesive layer and the plasma processing were not applied.

Comparative Example 2: A device package was provided under the same conditions as in Example 1, except that a polyurethane-based adhesive tape manufactured by Tapex Co. was applied as the adhesive layer.

Comparative Example 3: A device package was provided under the same conditions as in Example 1, except that the plasma processing was not applied.

Comparative Example 4: A device package was provided under the same conditions as in Example 2, except that the plasma processing was not applied.

Process conditions for each Example and Comparative Example are shown in Table 1 below.

### Evaluation Example: Reliability Evaluation

For the device packages of each Example and Comparative Example, a JEDEC MSL-3 test was performed under uHAST conditions. Specifically, the device packages were left for 96 hours in an atmosphere of 130 °C and 85 RH%.

Thereafter, a cross-section of the packaging substrate was observed with an optical microscope to evaluate whether delamination occurred between the first encapsulation layer and the second encapsulation layer, whether cracks occurred in the encapsulation layer, and whether chemical modification of the adhesive layer occurred.

In evaluation of occurrence of delamination, when delamination was not found, the result was evaluated as P, and when delamination was found, the result was evaluated as F.

In evaluation of occurrence of cracks in the encapsulation layer, when cracks were not found, the result was evaluated as P, and when cracks were found, the result was evaluated as F.

In evaluation of chemical modification of the adhesive layer, when discoloration of the adhesive layer was not found, the result was evaluated as P, and when discoloration of the adhesive layer was found, the result was evaluated as F.

Evaluation results for each Example and Comparative Example are shown in Table 2 below.

**[Table 1]**

| | Type of Adhesive Layer | Plasma Processing |
|---|---|---|
| Example 1 | Silicone resin | O |
| Example 2 | Epoxy resin | O |
| Example 3 | Acrylic resin | O |
| Comparative Example 1 | - | X |
| Comparative Example 2 | Polyurethane resin | O |
| Comparative Example 3 | Silicone resin | X |
| Comparative Example 4 | Epoxy resin | X |

**[Table 2]**

| | Delamination Evaluation | Crack Evaluation | Adhesive Layer Modification Evaluation |
|---|---|---|---|
| Example 1 | P | P | P |
| Example 2 | P | P | P |
| Example 3 | P | P | P |
| Comparative Example 1 | F | P | P |
| Comparative Example 2 | P | P | F |
| Comparative Example 3 | P | F | P |
| Comparative Example 4 | P | F | P |

From the delamination evaluation results of Table 2, Examples 1 to 3 were evaluated as P, whereas Comparative Example 1 was evaluated as F.

From the crack evaluation results, Examples 1 to 3 were evaluated as P, whereas Comparative Examples 3 and 4 were evaluated as F.

From the adhesive layer modification evaluation results, Examples 1 to 3 were evaluated as P, whereas Comparative Example 2 was evaluated as F.

Although preferred embodiments of the present disclosure have been described in detail above, the scope of the present disclosure is not limited thereto, and various modifications and improvements made by those skilled in the art using the basic concept of the present disclosure as defined in the following claims also fall within the scope of the present disclosure.

### [Description of Reference Numerals]

100: device package
10: device
20: encapsulation layer
21: first encapsulation layer
22: second encapsulation layer
30: adhesive layer
200: packaging substrate
50: core layer
51: cavity portion
511: device package mounting space
512: inner side surface of cavity

## Claims

1. A device package, comprising:
at least one device and an encapsulation layer surrounding the device,
wherein the encapsulation layer comprises a first encapsulation layer surrounding an upper surface of the device and a second encapsulation layer disposed below the first encapsulation layer, and
the device package further comprises an adhesive layer disposed between the first encapsulation layer and the second encapsulation layer.

2. The device package of claim 1,
wherein at least a portion of the adhesive layer is disposed in contact with a lower surface of the first encapsulation layer.

3. The device package of claim 1,
wherein a ratio of an area of the adhesive layer to an area of a lower surface of the device package is 15% or more.

4. The device package of claim 1,
wherein the adhesive layer comprises any one selected from the group consisting of a silicone-based adhesive, an epoxy-based adhesive, an acrylic-based adhesive, and combinations thereof.

5. The device package of claim 1,
comprising a first point located on a lower surface of the device and a second point located on a lower surface of the second encapsulation layer,
wherein a minimum value of a distance between the first point and the second point is 5 µm to 100 µm.

6. A packaging substrate, comprising:
a core layer and a cavity portion which is a space formed by recessing a portion of an upper surface of the core layer, and
the device package of claim 1 disposed in the cavity portion.

7. A method of manufacturing a device package, comprising:
a preliminary device package preparing step of preparing a preliminary device package comprising at least one device and a first encapsulation layer surrounding an upper surface of the device;
an adhesive layer forming step of forming an adhesive layer disposed on a lower surface of the preliminary device package; and
a second encapsulation layer forming step of forming a second encapsulation layer disposed below the lower surface of the preliminary device package on which the adhesive layer is formed to manufacture the device package.

8. The method of claim 7,
wherein the adhesive layer forming step comprises an adhesive layer disposing process of disposing the adhesive layer on the lower surface of the preliminary device package, and a plasma processing process of plasma-treating the lower surface of the preliminary device package on which the adhesive layer is disposed.

9. The method of claim 7,
wherein, in the adhesive layer forming step, at least a portion of the adhesive layer is formed to be in contact with a lower surface of the device.

10. The method of claim 7,
wherein, in the adhesive layer forming step, the adhesive layer is formed such that a ratio of an area of the adhesive layer to an area of the lower surface of the preliminary device package is 15% or more.

11. The method of claim 7,
wherein the adhesive layer comprises any one selected from the group consisting of a silicone-based adhesive, an epoxy-based adhesive, an acrylic-based adhesive, and combinations thereof.
